# EUROPEAN PATENT SPECIFICATION

(11) **EP 4 623 315 B1**
(45) Date of publication and mention of the grant of the patent: **02.09.2026**
(21) Application number: 23828923.5
(22) Date of filing: 22.11.2023
(51) Int. Cl.: G01R 31/36, G01R 31/367, G01N 29/11, G01N 29/44, G01N 29/46

(54) **SIMILARITY-BASED APPROACH FOR DETECTING DEFECTS IN BATTERY CELLS USING ACOUSTIC SIGNALS**
ÄHNLICHKEITSBASIERTER ANSATZ ZUR ERKENNUNG VON DEFEKTEN IN BATTERIEZELLEN UNTER VERWENDUNG AKUSTISCHER SIGNALE
APPROCHE BASÉE SUR LA SIMILARITÉ POUR LA DÉTECTION DE DÉFAUTS DANS DES ÉLÉMENTS DE BATTERIE À L'AIDE DE SIGNAUX ACOUSTIQUES

(30) Priority: 23.11.2022 US 202263384814 P
(43) Date of publication of application: 01.10.2025
(73) Proprietor: Liminal Insights, Inc., Emeryville, CA 94608-3631 (US)
(72) Inventor: DULANEY, Austin Ryan, Emeryville, California 94608 (US)
(74) Representative: Eisenführ Speiser
(86) International application number: PCT/US2023/081020
(87) International publication number: WO 2024/112953

(56) References cited:
- US-A1- 2021 175 553

## Description

### FIELD OF DISCLOSURE

The present disclosure is directed to systems used for monitoring and inspection of batteries based on acoustic signals. More specifically, exemplary aspects are directed to performing a similarity-based analysis of acoustic signals transmitted through a battery cell that would reduce and/or eliminate the need for retraining neural networks for identifying new and/or unknown defects in batteries.

### BACKGROUND

Demand for production of battery cells is on the rise owing to an increase in their use across various industries such as consumer electronics, automotive, clean energy, etc. Efficient and fast battery diagnostics methods are important for increasing quality, lifetime, and manufacturing process efficiency for batteries. In the case of manufacturing and production, reducing costs (e.g., price per kilowatt-hour (kWh)) is an important goal. Production costs and quality can be reduced by optimizing existing processes and/or introducing new technologies. For example, technological advances in the area of improved monitoring, manufacturing, and diagnostics can lead to cost efficiencies by shortening production process times (thus also reducing energy consumption during production), reducing waste due to damaged cells and cell parts, improving quality, etc.

US 2021/0175553 A1 relates to a method of acoustic signal based analysis using a previously generated reference model to determine characteristics of the battery cell and to a battery testing apparatus.

### BRIEF DESCRIPTION OF THE DRAWINGS

The accompanying drawings are presented to aid in the description of various aspects of the disclosure and are provided solely for illustration and not limitation.
FIG. 1 illustrates an example system for analyzing a sample using acoustic signal-based analysis, according to some aspects of the present disclosure;
FIG. 2 illustrates another example system for analyzing a sample using acoustic signal-based analysis, according to some aspects of the present disclosure;
FIG. 3 illustrates an example twin network that may be trained for detecting defects in battery cells, according to some aspects of the present disclosure;
FIG. 4 illustrates an example autoencoder neural network that may be trained and used for similarly-based defect detection, according to some aspects of the present disclosure;
FIG. 5 illustrates another example network that may be utilized in conjunction with twin networks of FIG. 3 for similarity-based defect detection, according to some aspects of the present disclosure;
FIG. 6 illustrates an example method of performing similarity-based defect detection, according to some aspects of the present disclosure; and
FIG. 7 illustrates an example computing device architecture of an example computing device, according to some aspects of the disclosure.

### SUMMARY

The present disclosure provides an approach for fast and efficient analysis of acoustic signals to identify and label anomalies in battery cells. As will be described below, this approach eliminates the need for defect specific training of neural networks, which can be cumbersome and inefficient due to growing and changing nature of possible battery defects.

In one aspect, a method includes receiving, as first input into a trained neural network, at least one first signal representative of acoustic measurements of at least one reference battery cell; receiving, as second input into the trained neural network, a second signal representative of acoustic measurements of an under-the-test battery cell; performing, using the trained neural network, an analysis of the at least one first signal and the second signal to determine if the second signal has a threshold similarity to the at least one first signal; and generating, as an output of the trained neural network, a defect identification for the under-the-test battery cell, based on whether the second signal has the threshold similarity to the at least one first signal or not.

In another aspect, the defect identification identifies the under-the-test battery as defect free if the second signal has the threshold similarity to the at least one first signal and the at least one first signal is a signal representing a defect free battery cell.

In another aspect, the defect identification identifies the under-the-test battery as having an unknown defect if the second signal does not have the threshold similarity to the at least one first signal and the at least one first signal includes one signal representing a defect free battery cell and one or more additional signals representing one or more known defects.

In another aspect, the trained neural network is not trained to identify a type of the unknown defect.

In another aspect, the trained neural network has a twin network architecture and the at least one first signal is received as input into a first one of two neural networks of the twin architecture and the second signal is received as input into a second one of the two neural networks of the twin network architecture.

In another aspect, the trained neural network is an autoencoder.

In another aspect, the method further includes reducing a dimensionality of the at least one first signal and the second signal using a recurring neural network.

In one aspect, a device includes one or more memories having computer-readable instructions corresponding to a trained neural network stored thereon; and one or more processors. The one or more processors are configured to execute the computer-readable instructions to receive, as first input into the trained neural network, at least one first signal representative of acoustic measurements of at least one reference battery cell; receive, as second input into the trained neural network, a second signal representative of acoustic measurements of an under-the-test battery cell; perform, using the trained neural network, an analysis of the at least one first signal and the second signal to determine if the second signal has a threshold similarity to the at least one first signal; and generate, as an output of the trained neural network, a defect identification for the under-the-test battery cell, based on whether the second signal has the threshold similarity to the at least one first signal or not.

In another aspect, the defect identification identifies the under-the-test battery as defect free if the second signal has the threshold similarity to the at least one first signal and the at least one first signal is a signal representing a defect free battery cell.

In another aspect, the defect identification identifies the under-the-test battery as having an unknown defect if the second signal does not have the threshold similarity to the at least one first signal and the at least one first signal includes one signal representing a defect free battery cell and one or more additional signals representing one or more known defects.

In another aspect, the trained neural network is not trained to identify a type of the unknown defect.

In another aspect, the trained neural network has a twin network architecture and the at least one first signal is received as input into a first one of two neural networks of the twin architecture and the second signal is received as input into a second one of the two neural networks of the twin network architecture.

In another aspect, the trained neural network is an autoencoder.

In another aspect, the computer-readable instructions further include instructions corresponding to a recurring neural network, which when executed by the one or more processors, cause the one or more processors to reduce a dimensionality of the at least one first signal and the second signal using the recurring neural network.

In one aspect, system includes an acoustic array configured to acoustically scan an under-the-test battery cell; and a trained neural network configured to receive, as first input into the trained neural network, at least one first signal representative of acoustic measurements of at least one reference battery cell; receive, as second input into the trained neural network, a second signal representative of acoustic measurements of the under-the-test battery cell; perform, using the trained neural network, an analysis of the at least one first signal and the second signal to determine if the second signal has a threshold similarity to the at least one first signal; and generate, as an output of the trained neural network, a defect identification for the under-the-test battery cell, based on whether the second signal has the threshold similarity to the at least one first signal or not.

In another aspect, the defect identification identifies the under-the-test battery as defect free if the second signal has the threshold similarity to the at least one first signal and the at least one first signal is a signal representing a defect free battery cell.

In another aspect, the defect identification identifies the under-the-test battery as having an unknown defect if the second signal does not have the threshold similarity to the at least one first signal and the at least one first signal includes one signal representing a defect free battery cell and one or more additional signals representing one or more known defects.

In another aspect, the trained neural network is not trained to identify a type of the unknown defect.

In another aspect, the trained neural network has a twin network architecture and the at least one first signal is received as input into a first one of two neural networks of the twin architecture and the second signal is received as input into a second one of the two neural networks of the twin network architecture.

In another aspect, the trained neural network is an autoencoder

### DETAILED DESCRIPTION

Certain aspects and embodiments of this disclosure are provided in the following description and related drawings. Alternate aspects may be devised without departing from the scope of the disclosure. Additionally, well-known elements of the disclosure will not be described in detail or will be omitted so as not to obscure the relevant details of the disclosure.

The word "exemplary" is used herein to mean "serving as an example, instance, or illustration." Any aspect described herein as "exemplary" is not necessarily to be construed as preferred or advantageous over other aspects. Likewise, the term "aspects of the invention" does not require that all aspects of the invention include the discussed feature, advantage or mode of operation.

The terminology used herein is for the purpose of describing particular aspects only and is not intended to be limiting of aspects of the disclosure. As used herein, the singular forms "a," "an," and "the" are intended to include the plural forms as well, unless the context clearly indicates otherwise. It will be further understood that the terms "comprises", "comprising," "includes," and/or "including," when used herein, specify the presence of stated features, integers, steps, operations, elements, and/or components, but do not preclude the presence or addition of one or more other features, integers, steps, operations, elements, components, and/or groups thereof.

Further, many aspects are described in terms of sequences of actions to be performed by, for example, elements of a computing device. It will be recognized that various actions described herein can be performed by specific circuits (e.g., application specific integrated circuits (ASICs)), by program instructions being executed by one or more processors, or by a combination of both. Additionally, these sequences of actions described herein can be considered to be embodied entirely within any form of computer readable storage medium having stored therein a corresponding set of computer instructions that upon execution would cause an associated processor to perform the functionality described herein. Thus, the various aspects of the invention may be embodied in a number of different forms, all of which have been contemplated to be within the scope of the claimed subject matter. In addition, for each of the aspects described herein, the corresponding form of any such aspects may be described herein as, for example, "logic configured to" perform the described action.

Demand for production of battery cells is on the rise owing to an increase in their use across various industries such as consumer electronics, automotive, clean energy, etc. Efficient and fast battery diagnostics methods are important for increasing quality, lifetime, and manufacturing process efficiency for batteries. In the case of manufacturing and production, reducing costs (e.g., price per kilowatt-hour (kWh)) is an important goal. Production costs and quality can be reduced by optimizing existing processes and/or introducing new technologies. For example, technological advances in the area of improved monitoring, manufacturing, and diagnostics can lead to cost efficiencies by shortening production process times (thus also reducing energy consumption during production), reducing waste due to damaged cells and cell parts, improving quality, etc.

One example aspect of monitoring and diagnosing a battery cell (or components thereof, or a battery module, a battery pack, etc.) during the manufacturing process is identification and labeling of defects (various known or to be developed physical defects such presence of foreign objects, non-uniform Solid Electrolyte Interphase (SEI) formation, etc.) based on information captured through acoustic signals that are transmitted through the battery cell and captured using pairs of transceivers, and/or identification and labeling of anomalies (deviations from baseline).

Processing of captured acoustic signals across the battery cell and hence identification and labeling (classification) of anomalies may be performed using trained machine learning/neural network models. Such trained models may be referred to as defect detection algorithms.

Defect detection (anomaly detection) algorithms often require access to multiple instances of specific defects to achieve satisfactory performance. This also means that these algorithms require extensive retraining or transfer learning in order to generalize to anomalies that have not been seen before. This leads to extensive training times and the need for very large datasets to distinguish one defect from another.

For instance, a particular model may be trained on large sets of data to detect a particular defect (e.g., defect A). However, it may so happen that a battery manufacturer may change their process for a particular phase of battery manufacturing (e.g., the electrode coating process). This change may result in a new form of defect (e.g., defect B). However, the initial neural network model has been trained to detect defect A but not defect B. A successful identification of defect B requires retraining the existing neural network model/machine learning models or training a new model to also detect defect B. In other words, without retraining the existing neural network to detect defect B, a battery cell scanned with the existing neural network that contains defect B, will be labeled as defect free (assuming the battery cell does not have any of the other defects that the existing neural network is trained to detect (e.g., defect A). This process becomes costly and inefficient as types of defects grow.

The present disclosure provides a solution that eliminates the need for training new models and/or retraining existing models.

In one aspect, twin neural networks may be trained and used to detect anomalies in battery cells. The process of training twin neural networks may involve (1) taking a 2-dimensional (2D) acoustic scan of a reference battery (or battery cell or its components, a battery module or a pack of cells) and a secondary battery (or battery cell or its components, a battery module or a pack of cells); (2) feeding the 2D acoustic scan of the reference battery and the secondary battery through one of the twin neural networks that gradually reduces the dimensionality of each scan and produces a meaningful low-dimensional representation of the reference battery and the secondary battery; (3) measuring the difference (e.g., a pairwise distance similarity which may also be referred to as hamming distance) between the representations of the reference and the secondary batteries; and (4) labeling the difference as a known defect. This labeled known defect may then be added to a bank of known defects that can later-on (e.g., during deployment of the trained neural network in real-time) be used to compare real-time scan of a given battery cell against to either identify the given battery cell as having a known defect, no detect at all, or flag the given cell as having a new type of defect that need to be assessed using any know or to be developed method.

In other words, if the reference battery and the secondary battery are the same (i.e., they are both baseline) a similarity distance between the two would be a configurable threshold that may be determined based on experiments and/or empirical studies. If they are different (i.e., one is baseline and one has an anomaly), the similarity distance between the two would be greater than the configurable threshold. This allows the system to learn a good general low-dimension representation for the reference battery and the secondary battery and label the difference as anomaly A. This also generates a general structure for comparing a new battery scan to a reference scan and/or the representation of anomaly A.

With a baseline reference available, any new scanned battery can be categorized as baseline or not. Once we identify a non-baseline battery, then we can incorporate ground truth (e.g., defect A) information to "name" the type of anomaly (e.g., anomaly A). Once an anomaly is named, then we have a reference for what that anomaly looks like.

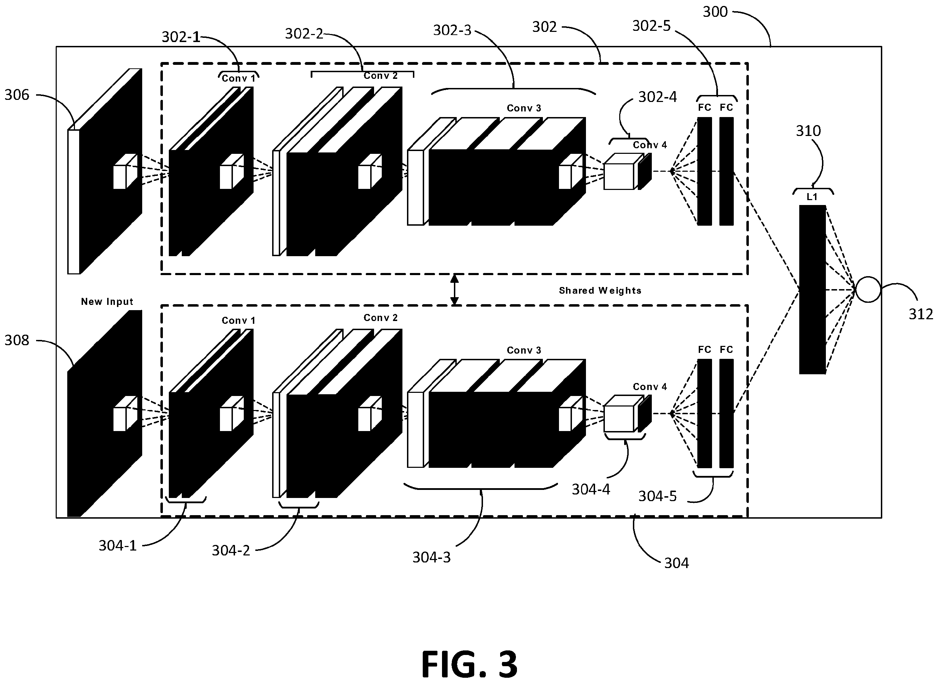

During deployment, any new battery can be compared to "baseline" and "defect A". If the new battery is different, the system may flag it as having an undefined anomaly. This framework makes it possible to have a good distinction between baseline batteries and anomalous ones, even if the algorithm does not know what type of anomaly is present in the newly-scanned battery or if the anomaly is one never seen before. This process will be further described below with reference to FIGs. 3-5.

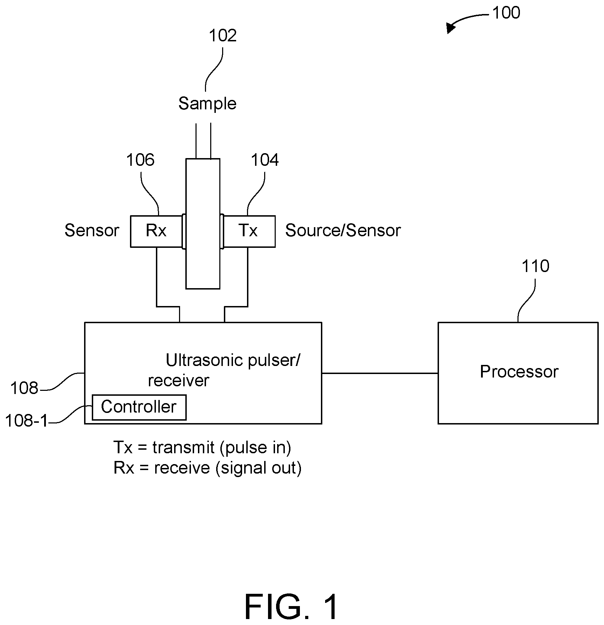

FIG. 1 illustrates an example system for analyzing a sample using acoustic signal-based analysis, according to some aspects of the present disclosure. System 100 may include sample 102. Sample 102 can include a battery cell or component thereof in any stage of production or manufacture of the battery cell or the individual components. In some examples, sample 102 can include a battery cell, electrolytes in various stages of wetting/distribution through a battery cell, one or more electrodes of the battery cell, thin films, separators, coated sheets, current collectors, electrode slurries, or materials for forming any of the above components during any stage of their formation. System 100 can include a transmitting transducer Tx 104 or other means for sending excitation sound signals into the battery cell (e.g., for transmitting a pulse or pulses of ultrasonic or other acoustic waves, vibrations, resonance measurements, etc., through the battery cell). System 100 can further include a receiving transducer Rx 106 or other means for receiving/sensing the sound signals, which can receive response signals generated from signals transmitted by Tx transducer 104. Any type of known or to be developed transducer for transmitting and receiving acoustic signals may be used as Tx transducer 104. Transmitted signals from Tx transducer 104, from one side of sample 102 on which Tx transducer 104 is located, may include input excitation signals. Reflected signals, e.g., from another side of sample 102, may include echo signals. It is understood that references to response signals may include both the input excitation signals and the echo signals. Further, Tx transducer 104 may also be configured to receive response signals, and similarly, Rx transducer 106 may also be configured to transmit acoustic signals. Any type of known or to be developed transducer for transmitting and receiving acoustic signals may be used as Rx transducer 106. Therefore, even though separately illustrated as Tx and Rx, the functionalities of these transducers may be for both sending and receiving acoustic signals. In various alternatives, even if not specifically illustrated, one or more Tx transducers and one or more Rx transducers can be placed on the same side or wall of sample 102, or on different (e.g., opposite) sides. Throughout this disclosure, reference may be made to a transducer pair (a transmitting transducer and a receiving transducer). Transducer Tx 104 and transducer Rx 106 may form a pair of transducers.

Acoustic pulser/receiver 108 can be coupled to Tx and Rx transducers 104, 106 for controlling the transmission of acoustic signals (e.g., ultrasound signals) and receiving response signals. Acoustic pulser/receiver 108 may include a controller 108-1 for adjusting the amplitude, frequency, and/or other signal features of the transmitted signals. Acoustic pulser/receiver 108 may also receive the signals from Rx transducers 106. In some examples, acoustic pulser/receiver 108 may be configured as a combined unit, while in some examples, an acoustic pulser for transmitting excitation signals through Tx transducer 104 can be a separate unit in communication with a receiver for receiving signals from Rx transducer 106. Processor 110 in communication with acoustic pulser/receiver 108 may be configured to store and analyze the response signal waveforms according to this disclosure. Although representatively shown as a single processor, processor 110 can include one or more processors, including remote processors, cloud computing infrastructure, etc.

Although not explicitly shown in FIG. 1, more than one Tx transducer and/or more than one Rx transducer can be placed in one or more spatial locations across sample 102. This allows studying a spatial variation of acoustic signal features across sample 102. A multiplexer can be configured in communication with the acoustic pulser/receiver 108 for separating and channeling the excitation signals to be transmitted and the response signals received. In some examples, various acoustic couplants can be used (e.g., solid, liquid, or combinations thereof) for making or enhancing contact between Tx and Rx transducers 104, 106 and sample 102. Furthermore, various attachment or fixturing mechanisms (e.g., pneumatic, compression, screws, etc.) can also be used for establishing or enhancing the contact between Tx and Rx transducers 104, 106 and sample 102.

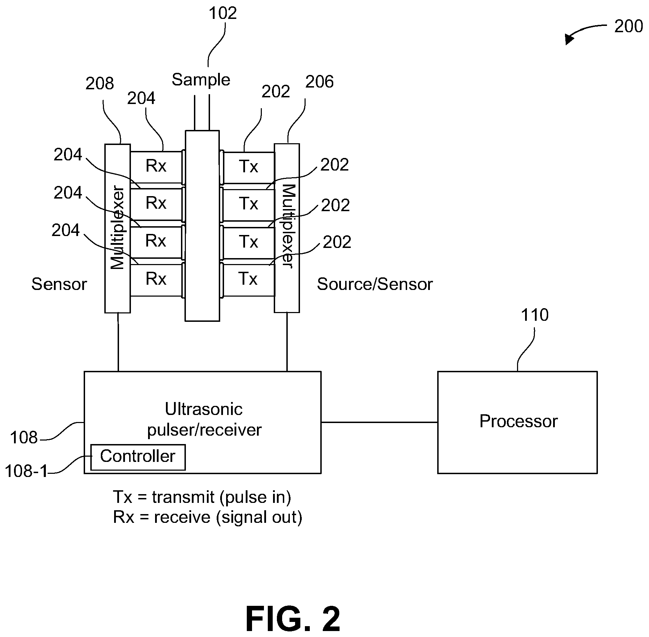

FIG. 2 illustrates another example system for analyzing a sample using acoustic signal-based analysis, according to some aspects of the present disclosure. In comparison with FIG. 1, system 200 of FIG. 2 illustrates a system in which multiple pairs of transmitting and receiving transducers are used for transmitting signals through a sample under testing (e.g., a battery cell) and performing acoustic signal-based analysis of the sample.

System 200 includes several transmitting Tx transducers 202 (each of which may be the same as Tx transducer 104 of FIG. 1). While an array of four examples Tx transducers 202 are shown in FIG. 2, the disclosure is not limited to four. Any number of transducers may be used (e.g., any number of Tx transducers ranging from 1 to 10, 15, 20, etc.).

Similarly, system 200 includes a number of receiving (sensing) Rx transducers 204 (each of which may be the same as Rx transducer 106 of FIG. 1). While an array of four examples Rx transducers 204 are shown in FIG. 2, the disclosure is not limited to four. Any number of transducers may be used (e.g., any number of Rx transducers ranging from 1 to 10, 15, 20, etc.). Any given Tx transducer 202 and Rx transducer 204 may form a transducer pair (FIG. 2 illustrates four transducer pairs). FIG. 2 also illustrates a multiplexer 206 coupled to the array of four Tx transducers 202 and a multiplexer 208 coupled to the array of four Rx transducers 204. As described above, each one of multiplexers 206 and 208 may be configured in communication with the acoustic pulser/receiver 108 for separating and channeling the excitation signals to be transmitted and the response signals received, respectively. In some examples, various acoustic couplants can be used (e.g., solid, liquid, or combinations thereof) for making or enhancing contact between Tx and Rx transducers 202, 204 and sample 102. Furthermore, various attachment or fixturing mechanisms (e.g., pneumatic, compression, screws, etc.) can also be used for establishing or enhancing the contact between Tx and Rx transducers 202, 204 and sample 102.

Spacing between Tx transducers 202 and Rx transducers 204 may be uniform and the same. System 200 also includes additional elements such as sample 102, ultrasonic pulser/receiver 108 (controller 108-1), processors 110, each of which may be the same as the corresponding counterpart described above with reference to FIG. 1 and hence will not be described further for sake of brevity.

FIG. 3 illustrates an example twin network that may be trained for similarity-based defect detection in battery cells, according to some aspects of the present disclosure.

Twin network architecture 300 can include two neural networks 302 and 304 that have the same structure. Both networks 302 and 304 use the same weights and each may take a different 'image' as input. In one non-limiting example, neural networks 302 and 304 may be convolutional neural networks. As shown in FIG. 3 each neural network 302 and 304 may have a multi-layer convolutional structure. For instance, neural network 302 is shown to have convolutional layers 302-1, 302-2, 302-3, and 302-4. As matrix of data associated with an acoustic scan of a battery pass through each convolutional layer, the dimensionality of the data is reduced until a final reduced (low-dimensional) representation of the scanned data of a battery cell is obtained at Fully Connected (FC) layer 302-5.

Similarly, neural network 304 is shown to have convolutional layers 304-1, 304-2, 304-3, and 304-4. As matrix of data associated with an acoustic scan of a battery pass through each convolutional layer, the dimensionality of the data is reduced until a final reduced (low-dimensional) representation of the scanned data of a battery cell is obtained at Fully Connected (FC) layer 304-5.

For training twin network architecture 300, Reference image (input) 306 that is a vector of acoustic data captured for a reference battery or battery cell (this reference battery may be referred to as a 'baseline battery' known to have no defects) may be inputted into neural network 302. An 'image' may also be referred to as an acoustic representative image. In some examples, an image may be defined as a collection/table of values of independent and dependent acoustic metrics obtained by processing acoustics signals received after transmission through a battery. Acoustic image may also be the collection of acoustic waveforms collected over a 2-D scan of the battery cell. For example, an acoustic image can be a 2-D collection/table of acoustic signals or their derived metrics obtained by processing acoustic signals received after transmission through a battery, from across the surface or face of a battery, etc.

At the same time, secondary image (input) 308 that is a vector of acoustic data captured for another battery cell being tested (a secondary battery) may be inputted into neural network 304. For the training phase, the secondary battery may either be a defect free battery (e.g., same as reference image 306) or be a battery cell with a known defect (e.g., defect A). Each of networks 302 and 304 may reduce the corresponding acoustic representative image in dimensionality and perform a computation to determine a distance between the two vectors of respect reference image 306 and secondary image 308 at FC layers 302-5 and 304-5, respectively. The difference may result in vector 310.

In one example, if the difference between FC layers 302-5 and 304-5 is less than a configurable threshold, resulting vector 310 may be taken as a meaningful low-dimensional representation of reference image 306 (defect free battery). If the difference is more than such configurable threshold and given that in training phase, the battery corresponding to secondary image 308 is known to have defect A, the resulting vector 310 may be labeled as a meaningful low-dimensional representation of defect A. This process may be repeated to create a bank (may also be referred to as a dataset or a database or a collection) of meaningful low-dimensional representations of known defects during training, to be used when trained twin network architecture 300 is deployed for real-time use.

As noted above, a Euclidean distance may be used as an indication of difference between FC layers 302-5 and 304-5. A distance of 0 (or below a configurable threshold) may indicate that the battery cell being tested is the same as the 'reference battery' and a distance of 1 (or above the configurable threshold) may indicate that the battery cell being tested has a defect (e.g., defect A).

Output 312 may be a single value output that identifies the battery or battery cell associated with secondary image 308 as being defect free, having defect A, having defect B, having an unknown defect, etc. Output 312 may be a numerical value or an actual label (in words) that identifies the battery cell being acoustically examined (e.g., the label being defect, free, defect A, defect B, unknown defect, etc.)

In one example, when the battery being tested is flagged as having an anomaly, such anomaly may be analyzed and labeled as a particular type of anomaly (e.g., defect A). Thereafter, input 'image' 306 may either be that of the reference battery or that of the 'image' with defect A. In one example, the baseline image may be updated to be any ground truth image for a defect free battery cell and/or the ground truth image for a battery cell with defect A or any other labeled anomaly. Therefore, any new battery cell whose 'image' is used as input image 308 can be categorized as either the same as the reference battery, as having defect A or as a battery cell some other defect (unknown defect). The "other defect"/"unknown defect" may then be analyzed and classified as defect B, which is then used as another baseline image for comparison along with the image of the reference battery cell and that of a battery cell with defect A. The addition of baseline images generates a library of reference images including a defect free baseline, defect A, defect B, and so on that each new input 'image' 306 can be compared against. This process may be repeated for every new defect that may be identified without having to retrain any neural network to detect and classify the newly identified defect. In some examples, a reference library of defect free baseline battery cell and any labeled defect (e.g., defect A, B, C, etc.) may be created and used as the baseline image 306 when a new incoming image 308 is analyzed.

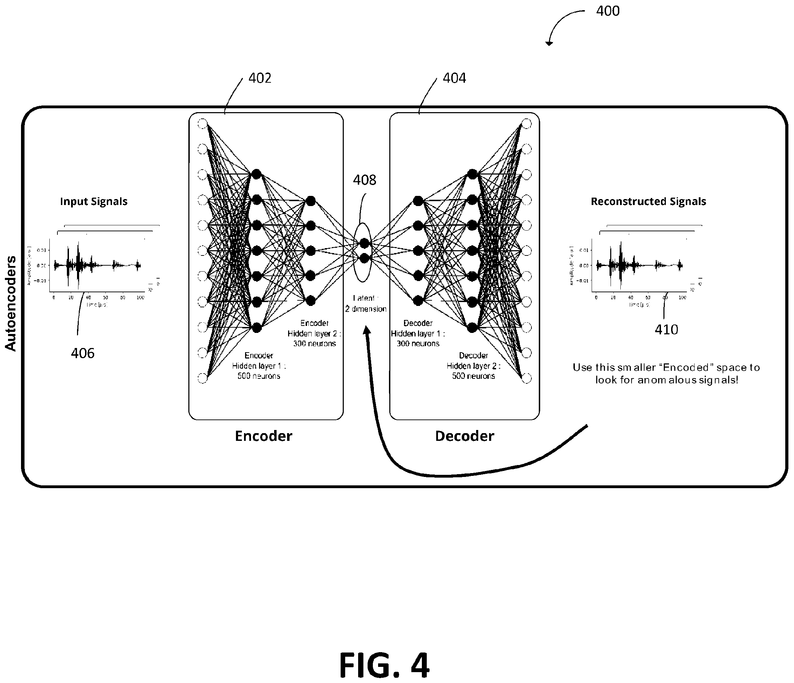

FIG. 4 illustrates an example autoencoder neural network that may be trained and used for similarly-based defect detection, according to some aspects of the present disclosure. Architecture 400 of FIG. 4 shows autoencoder 402 in the training phase. In this phase, decoder 404 is also utilized in order to train and validate autoencoder 402 before deploying autoencoder 402 for use in similarity-based defect detection.

It is also noted that autoencoder 402 may be utilized on its own for similarity-based defect detection (e.g., instead of twin network architecture 300 of FIG. 3). In another example, autoencoder 402 may be utilized as a further dimensionality-reduction tool for input images to twin network architecture 300. In other words, autoencoder 402 may be used to reduce dimensionality of images 306 and that of an "under-the-test"/new battery cell prior to inputting them into neural networks 302 and 304, respectively.

Autoencoder architecture 400 of FIG. 4 may be an unsupervised system with encoder neural network 402 and a decoder neural network 404. An input acoustic representative image 406 (may also be referred to as input signal 406 or input image 406 and can be the same as reference image 306). Encoder 402 may be a multi-layered encoder as shown in FIG. 4. Once trained, an input image 406 (input signal 406) may be inputted into autoencoder 402 and a dimensionally reduced version of input image 406 may be provided as output 408. In one example, output 408 may be 2-dimensional.

In training, input signals are provided to autoencoder 402 and corresponding output 408 is then provided as input into decoder 404. At output 410 of decoder 404, reconstructed version of input image 406 is obtained. Output 410 is then compared to input image 406 in order to determine (validate) performance of autoencoder 402 and ensure that meaningful information included in input image 406 (acoustic data representative of physical characteristics of a given battery cell) is not lost.

Once validated, autoencoder 402 may receive as input a representation of a baseline image and/or representation(s) of known defect(s) and provide as output a low-dimensional representation of that input (e.g., a 2D representation). Autoencoder 402 may similarly receive as input, a signal of acoustic measurements of a battery cell being tested and provide a low-dimensional representation of that input at output 408. Low-dimensional representation of baseline/known defect image(s) may then be compared to low-dimensional representation of a battery cell under testing in order to identify the battery cell under testing as defect free, having one or more of the known defects, or having an unknown defect that may trigger further analysis to determine the exact type of the unknow defect.

As noted, low-dimensional representation of baseline/known defect image(s) and that of a battery under testing during deployment, may then be provided as inputs 306 and 308 to twin network architecture 300 in order to perform the similarly-based defect detection as described above with reference to FIG. 3.

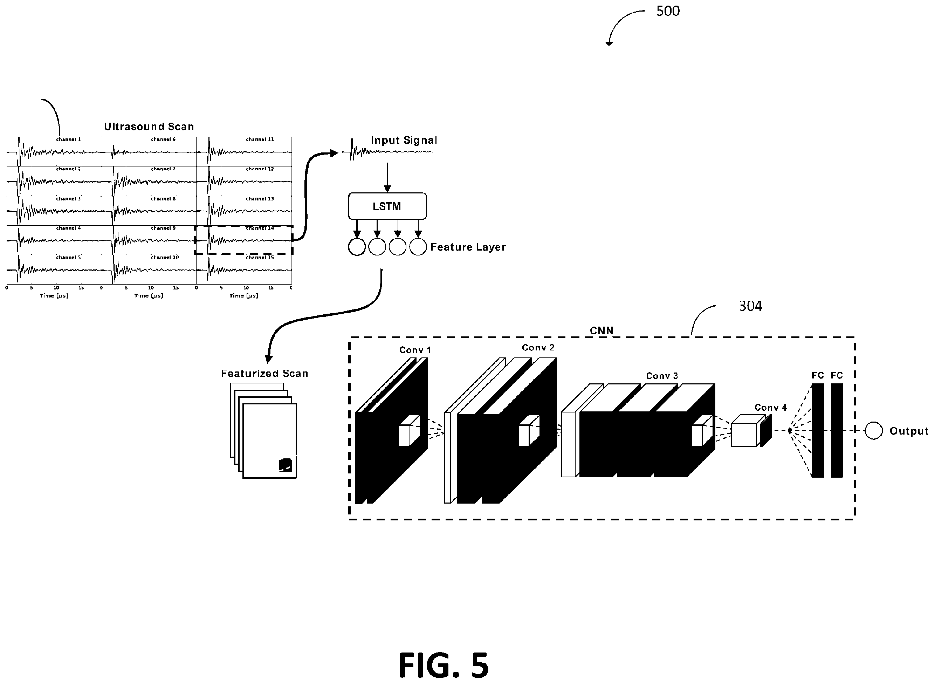

FIG. 5 illustrates another example network that may be utilized in conjunction with twin networks of FIG. 3 and/or autoencoder 402 of FIG. 4 and/or autoencoder 402 of FIG. 4 for similarity-based defect detection, according to some aspects of the present disclosure.

Architecture 500 is an example whereby an input signal (e.g., results of scanning a battery cell that is undergoing testing after twin network architecture 300 or autoencoder 402 is deployed) may undergo an extra layer of processing to reduce dimensionality thereof before similarity-based defect detection as described above with reference to FIGs. 3 and 4 can be performed.

As can be seen in example of FIG. 5, a scan of a battery cell can be made via an array of transducers (e.g., an array of 16 transducers). This results in 16 signals representative of the battery across the 16 transducers (16 channels). These 16 signals are shown as input signals 502. Each channel of input signals 502 may be provided as input into neural network 504. Neural network 504 may be a recurrent neural network (RNN) such as, but not limited to, a Long Short-Term Memory (LSTM) network. Alternatively, a convolutional neural network (e.g., a 1D convolutional neural network) may be used as neural network 504. Output of LSTM 504 may be a 4-dimensional representation of each channel of input signals 502. Each dimension of each channel may be placed in one layer of featurized scan set 506. Featurized scan set 506 may then be provided as input 308 into neural network 304 of FIG. 3 or input signal 406 into autoencoder 402 to be compared to baseline/known defect(s) representation(s) for similarity-based defect detection as described above with reference to FIGs. 3 and 4.

Those of skill in the art will appreciate that information and signals may be represented using any of a variety of different technologies and techniques. For example, data, instructions, commands, information, signals, bits, symbols, and chips that may be referenced throughout the above description may be represented by voltages, currents, electromagnetic waves, magnetic fields or particles, optical fields or particles, or any combination thereof.

Further, those of skill in the art will appreciate that the various illustrative logical blocks, modules, circuits, and algorithm steps described in connection with the aspects disclosed herein may be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the present invention.

Accordingly, an aspect of the invention can include a computer-readable media embodying a method of improvements to one or more processes in the manufacturing of battery cells using acoustic signal-based analysis. Accordingly, the invention is not limited to illustrated examples and any means for performing the functionality described herein are included in aspects of the invention.

The components of the computing device can be implemented in circuitry. For example, the components can include and/or can be implemented using electronic circuits or other electronic hardware, which can include one or more programmable electronic circuits (e.g., microprocessors, graphics processing units (GPUs), digital signal processors (DSPs), central processing units (CPUs), and/or other suitable electronic circuits), and/or can include and/or be implemented using computer software, firmware, or any combination thereof, to perform the various operations described herein. The computing device may further include a display (as an example of the output device or in addition to the output device), a network interface configured to communicate and/or receive the data, any combination thereof, and/or other component(s). The network interface may be configured to communicate and/or receive Internet Protocol (IP) based data or other type of data.

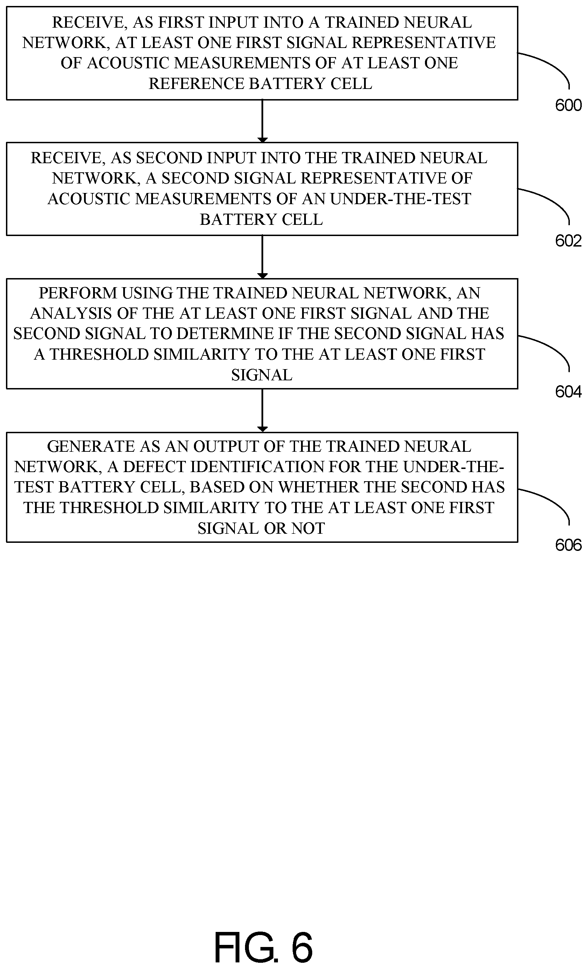

FIG. 6 illustrates an example computing device architecture of an example computing device, in accordance with some aspects of the disclosure. In one example, process of FIG. 6 may be performed by processor 110 described above with reference to FIGs. 1 and 2. It should be understood that processor 110 has one or more associated memories with computer-readable instructions stored therein, which when executed by processor 110, cause processor 110 to perform steps of FIG. 6 described below. Processor 110 may also be referred to as a controller, a device, etc. Processor 110 may be local to system 110 and/or system 200 or may be remote (e.g., cloud-based) and communicatively coupled thereto.

Once trained, processor 110 may deploy twin network architecture 300 of FIG. 3, and/or autoencoder 402 of FIG. 4.

At step 600, processor 110 may receive, as first input into a trained neural network, at least one first signal representative of acoustic measurements of at least one reference battery cell. In one example, the at least one first signal may include low-dimensional representation of a baseline battery cell and/or known defects (e.g., defect A, defect B, etc.) identified during training of the neural network as described above. Hence, a reference battery cell may be a defect free battery cell or a battery cell with a known defect. First input may be input image/signal 306 or 408 described above with reference to FIGs. 3 and 4.

At step 602, processor 110 may receive, as second input into the trained neural network, a second signal representative of acoustic measurements of an under-the-test battery cell. In one example, an under-the-test battery cell may be a cell that is currently progressing through a manufacturing process and is subject to acoustic testing by system 100/200 of FIGs. 1 and 2.

At step 604, processor 110 may perform using the trained neural network, an analysis of the at least one first signal and the second signal to determine if the second signal has a threshold similarity to the at least one first signal. As described above, this analysis may include performing a similarity-based comparison of low-dimensional representations of the first signal(s) and the second signal of the under-the-test battery cell (e.g., comparison of FC 302-5 and 304-5 as described with reference to FIG. 3 above).

In one example, the threshold similarity may refer to the configurable threshold described above with reference to FIGs. 3 and 4.

In one example, performing the analysis may further include reducing a dimensionality of the at least one first signal and the second signal using a Long Short-Term Memory (LSTM) neural network as described above with reference to FIG. 5.

At step 606, processor 110 may generate a defect identification for the under-the-test battery cell based on whether the second signal has a threshold similarity to the one or more first signal(s) or not.

As described, in one example, the defect identification may identify the under-the-test battery cell as defect free if the second signal has the threshold similarity to the at least one first signal and the at least one first signal is a signal representing a defect free battery cell. If the at least one signal also includes signals representing one or more known defects, the defect identification may identify the under-the-test battery cell as having one or more of the known defects if the second signal has the threshold similarity to any of the signals representing the one or more known defects.

In another example, the defect identification may identify the under-the-test battery cell as having an unknown defect if the second signal does not have the threshold similarity to the at least one first signal and the at least one first signal includes one signal representing a defect free battery cell and one or more additional signals representing one or more known defects. Accordingly, the trained neural network need not be trained to identify a type of the unknown defect.

In one example, the trained neural network has a twin network architecture (as described with reference to FIG. 3) and the at least one first signal is received as input into a first one of two neural networks of the twin architecture and the second signal is received as input into a second one of the two neural networks of the twin network architecture.

In another example, the trained neural network is an autoencoder as described with reference to FIG. 4.

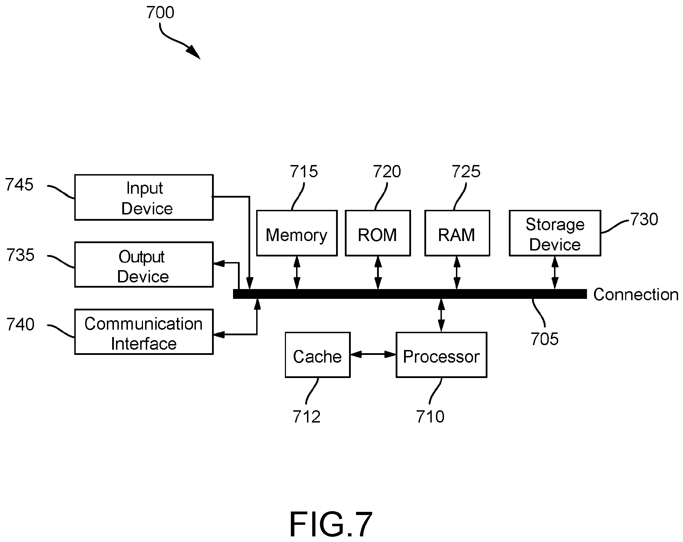

FIG. 7 illustrates an example computing device architecture of an example computing device, in accordance with some aspects of the disclosure. Device architecture 700 of an example computing device which can be used as various components of system 100 or 200 (e.g., processor 110) implement various techniques described herein. The components of the computing device architecture 700 are shown in electrical communication with each other using a connection 705, such as a bus. The example computing device architecture 700 includes a processing unit (CPU or processor) 710 and a computing device connection 705 that couples various computing device components including the computing device memory 715, such as read only memory (ROM) 720 and random-access memory (RAM) 725, to the processor 710.

The computing device architecture 700 can include a cache of high-speed memory connected directly with, in close proximity to, or integrated as part of the processor 710. The computing device architecture 700 can copy data from the memory 715 and/or the storage device 730 to the cache 712 for quick access by the processor 710. In this way, the cache can provide a performance boost that avoids processor 710 delays while waiting for data. These and other modules can control or be configured to control the processor 710 to perform various actions. Other computing device memory 715 may be available for use as well. The memory 715 can include multiple different types of memory with different performance characteristics. The processor 710 can include any general-purpose processor and a hardware or software service stored in storage device 730 and configured to control the processor 710 as well as a special-purpose processor where software instructions are incorporated into the processor design. The processor 710 may be a self-contained system, containing multiple cores or processors, a bus, memory controller, cache, etc. A multi-core processor may be symmetric or asymmetric.

To enable user interaction with the computing device architecture 700, an input device 745 can represent any number of input mechanisms, such as a microphone for speech, a touch-sensitive screen for gesture or graphical input, keyboard, mouse, motion input, speech and so forth. An output device 735 can also be one or more of a number of output mechanisms known to those of skill in the art, such as a display, projector, television, speaker device. In some instances, multimodal computing devices can enable a user to provide multiple types of input to communicate with the computing device architecture 700. The communication interface 740 can generally govern and manage the user input and computing device output. There is no restriction on operating on any particular hardware arrangement and therefore the basic features here may easily be substituted for improved hardware or firmware arrangements as they are developed.

Storage device 730 is a non-volatile memory and can be a hard disk or other types of computer readable media which can store data that are accessible by a computer, such as magnetic cassettes, flash memory cards, solid state memory devices, digital versatile disks, cartridges, random access memories (RAMs) 725, read only memory (ROM) 720, and hybrids thereof. The storage device 730 can include software, code, firmware, etc., for controlling the processor 710. Other hardware or software modules are contemplated. The storage device 730 can be connected to the computing device connection 705. In one aspect, a hardware module that performs a particular function can include the software component stored in a computer-readable medium in connection with the necessary hardware components, such as the processor 710, connection 705, output device 735, and so forth, to carry out the function.

The term "computer-readable medium" includes, but is not limited to, portable or non-portable storage devices, optical storage devices, and various other mediums capable of storing, containing, or carrying instruction(s) and/or data. A computer-readable medium may include a non-transitory medium in which data can be stored and that does not include carrier waves and/or transitory electronic signals propagating wirelessly or over wired connections. Examples of a non-transitory medium may include, but are not limited to, a magnetic disk or tape, optical storage media such as compact disk (CD) or digital versatile disk (DVD), flash memory, memory or memory devices. A computer-readable medium may have stored thereon code and/or machine-executable instructions that may represent a procedure, a function, a subprogram, a program, a routine, a subroutine, a module, a software package, a class, or any combination of instructions, data structures, or program statements. A code segment may be coupled to another code segment or a hardware circuit by passing and/or receiving information, data, arguments, parameters, or memory contents. Information, arguments, parameters, data, etc. may be passed, forwarded, or transmitted via any suitable means including memory sharing, message passing, token passing, network transmission, or the like.

In some embodiments the computer-readable storage devices, mediums, and memories can include a cable or wireless signal containing a bit stream and the like. However, when mentioned, non-transitory computer-readable storage media expressly exclude media such as energy, carrier signals, electromagnetic waves, and signals per se.

Specific details are provided in the description above to provide a thorough understanding of the embodiments and examples provided herein. However, it will be understood by one of ordinary skill in the art that the embodiments may be practiced without these specific details. For clarity of explanation, in some instances the present technology may be presented as including individual functional blocks comprising devices, device components, steps or routines in a method embodied in software, or combinations of hardware and software. Additional components may be used other than those shown in the figures and/or described herein. For example, circuits, systems, networks, processes, and other components may be shown as components in block diagram form in order not to obscure the embodiments in unnecessary detail. In other instances, well-known circuits, processes, algorithms, structures, and techniques may be shown without unnecessary detail in order to avoid obscuring the embodiments.

Individual embodiments may be described above as a process or method which is depicted as a flowchart, a flow diagram, a data flow diagram, a structure diagram, or a block diagram. Although a flowchart may describe the operations as a sequential process, many of the operations can be performed in parallel or concurrently. In addition, the order of the operations may be re-arranged. A process is terminated when its operations are completed, but could have additional steps not included in a figure. A process may correspond to a method, a function, a procedure, a subroutine, a subprogram, etc. When a process corresponds to a function, its termination can correspond to a return of the function to the calling function or the main function.

Processes and methods according to the above-described examples can be implemented using computer-executable instructions that are stored or otherwise available from computer-readable media. Such instructions can include, for example, instructions and data which cause or otherwise configure a general-purpose computer, special purpose computer, or a processing device to perform a certain function or group of functions. Portions of computer resources used can be accessible over a network. The computer executable instructions may be, for example, binaries, intermediate format instructions such as assembly language, firmware, source code. Examples of computer-readable media that may be used to store instructions, information used, and/or information created during methods according to described examples include magnetic or optical disks, flash memory, USB devices provided with non-volatile memory, networked storage devices, and so on.

Devices implementing processes and methods according to these disclosures can include hardware, software, firmware, middleware, microcode, hardware description languages, or any combination thereof, and can take any of a variety of form factors. When implemented in software, firmware, middleware, or microcode, the program code or code segments to perform the necessary tasks (e.g., a computer-program product) may be stored in a computer-readable or machine-readable medium. A processor(s) may perform the necessary tasks. Typical examples of form factors include laptops, smart phones, mobile phones, tablet devices or other small form factor personal computers, personal digital assistants, rackmount devices, standalone devices, and so on. Functionality described herein also can be embodied in peripherals or add-in cards. Such functionality can also be implemented on a circuit board among different chips or different processes executing in a single device, by way of further example.

The instructions, media for conveying such instructions, computing resources for executing them, and other structures for supporting such computing resources are example means for providing the functions described in the disclosure.

In the foregoing description, aspects of the application are described with reference to specific embodiments thereof, but those skilled in the art will recognize that the application is not limited thereto. Thus, while illustrative embodiments of the application have been described in detail herein, it is to be understood that the inventive concepts may be otherwise variously embodied and employed, and that the appended claims are intended to be construed to include such variations, except as limited by the prior art. Various features and aspects of the above-described application may be used individually or jointly. Further, embodiments can be utilized in any number of environments and applications beyond those described herein without departing from the scope of the specification. The specification and drawings are, accordingly, to be regarded as illustrative rather than restrictive. For the purposes of illustration, methods were described in a particular order. It should be appreciated that in alternate embodiments, the methods may be performed in a different order than that described.

One of ordinary skill will appreciate that the less than ("<") and greater than (">") symbols or terminology used herein can be replaced with less than or equal to (" ≤ ") and greater than or equal to (" ≥ ") symbols, respectively, without departing from the scope of this description.

Where components are described as being "configured to" perform certain operations, such configuration can be accomplished, for example, by designing electronic circuits or other hardware to perform the operation, by programming programmable electronic circuits (e.g., microprocessors, or other suitable electronic circuits) to perform the operation, or any combination thereof.

The phrase "coupled to" refers to any component that is physically connected to another component either directly or indirectly, and/or any component that is in communication with another component (e.g., connected to the other component over a wired or wireless connection, and/or other suitable communication interface) either directly or indirectly.

While the foregoing disclosure shows illustrative aspects of the invention, it should be noted that various changes and modifications could be made herein without departing from the scope of the invention as defined by the appended claims. The functions, steps and/or actions of the method claims in accordance with the aspects of the invention described herein need not be performed in any particular order. Furthermore, although elements of the invention may be described or claimed in the singular, the plural is contemplated unless limitation to the singular is explicitly stated.

Claim language or other language reciting "at least one of" a set and/or "one or more" of a set indicates that one member of the set or multiple members of the set (in any combination) satisfy the claim. For example, claim language reciting "at least one of A and B" or "at least one of A or B" means A, B, or A and B. In another example, claim language reciting "at least one of A, B, and C" or "at least one of A, B, or C" means A, B, C, or A and B, or A and C, or B and C, or A and B and C. The language "at least one of" a set and/or "one or more" of a set does not limit the set to the items listed in the set. For example, claim language reciting "at least one of A and B" or "at least one of A or B" can mean A, B, or A and B, and can additionally include items not listed in the set of A and B.

## Claims

1. A method comprising:
receiving (600), as first input into a trained neural network, at least one first signal representative of acoustic measurements of at least one reference battery cell;
receiving (602), as second input into the trained neural network, a second signal representative of acoustic measurements of an under-the-test battery cell;
performing (604), using the trained neural network, an analysis of the at least one first signal and the second signal to determine if the second signal has a threshold similarity to the at least one first signal; and
generating (606), as an output of the trained neural network, a defect identification for the under-the-test battery cell, based on whether the second signal has the threshold similarity to the at least one first signal or not.

2. The method of claim 1,
wherein the defect identification identifies the under-the-test battery cell as defect free if the second signal has the threshold similarity to the at least one first signal and the at least one first signal is a signal representing a defect free battery cell; and/or
wherein the defect identification identifies the under-the-test battery cell as having an unknown defect if the second signal does not have the threshold similarity to the at least one first signal and the at least one first signal includes one signal representing a defect free battery cell and one or more additional signals representing one or more known defects, wherein, in particular, the trained neural network is not trained to identify a type of the unknown defect.

3. The method of claim 1, wherein the trained neural network has a twin network architecture (300) and the at least one first signal is received as input into a first one (302) of two neural networks (302, 304) of the twin architecture (300) and the second signal is received as input into a second one (304) of the two neural networks (302, 304) of the twin network architecture (300).

4. The method of claim 1, wherein the trained neural network is an autoencoder (400, 402).

5. The method of claim 1, further comprising:
reducing a dimensionality of the at least one first signal and the second signal using a recurring neural network.

6. A device (700) comprising:
one or more memories (715, 720, 725, 730) having computer-readable instructions corresponding to a trained neural network stored thereon; and
one or more processors (710) configured to execute the computer-readable instructions to:
receive (600), as first input into the trained neural network, at least one first signal representative of acoustic measurements of at least one reference battery cell;
receive (602) , as second input into the trained neural network, a second signal representative of acoustic measurements of an under-the-test battery cell;
perform (604), using the trained neural network, an analysis of the at least one first signal and the second signal to determine if the second signal has a threshold similarity to the at least one first signal; and
generate (606), as an output of the trained neural network, a defect identification for the under-the-test battery cell, based on whether the second signal has the threshold similarity to the at least one first signal or not.

7. The device (700) of claim 6,
wherein the defect identification identifies the under-the-test battery cell as defect free if the second signal has the threshold similarity to the at least one first signal and the at least one first signal is a signal representing a defect free battery cell; and/or
wherein the defect identification identifies the under-the-test battery cell as having an unknown defect if the second signal does not have the threshold similarity to the at least one first signal and the at least one first signal includes one signal representing a defect free battery cell and one or more additional signals representing one or more known defects, wherein, in particular, the trained neural network is not trained to identify a type of the unknown defect.

8. The device (700) of claim 6, wherein the trained neural network has a twin network architecture (300) and the at least one first signal is received as input into a first one (302) of two neural networks (302, 304) of the twin architecture (300) and the second signal is received as input into a second one (304) of the two neural networks (302, 304) of the twin network architecture (300).

9. The device (700) of claim 6, wherein the trained neural network is an autoencoder (400, 402).

10. The device (700) of claim 6, wherein the computer-readable instructions further include instructions corresponding to a recurring neural network, which when executed by the one or more processors, cause the one or more processors to reduce a dimensionality of the at least one first signal and the second signal using the recurring neural network.

11. A system (100, 200) comprising:
an acoustic array configured to acoustically scan an under-the-test battery cell; and
a trained neural network configured to:
receive (600), as first input into the trained neural network, at least one first signal representative of acoustic measurements of at least one reference battery cell;
receive (602), as second input into the trained neural network, a second signal representative of acoustic measurements of the under-the-test battery cell;
perform (604), using the trained neural network, an analysis of the at least one first signal and the second signal to determine if the second signal has a threshold similarity to the at least one first signal; and
generate (606), as an output of the trained neural network, a defect identification for the under-the-test battery cell, based on whether the second signal has the threshold similarity to the at least one first signal or not.

12. The system (100, 200) of claim 11,
wherein the defect identification identifies the under-the-test battery cell as defect free if the second signal has the threshold similarity to the at least one first signal and the at least one first signal is a signal representing a defect free battery cell; and/or
wherein the defect identification identifies the under-the-test battery cell as having an unknown defect if the second signal does not have the threshold similarity to the at least one first signal and the at least one first signal includes one signal representing a defect free battery cell and one or more additional signals representing one or more known defects, wherein, in particular, the trained neural network is not trained to identify a type of the unknown defect.

13. The system (100, 200) of claim 11, wherein the trained neural network has a twin network architecture (300) and the at least one first signal is received as input into a first one (302) of two neural networks (302, 304) of the twin architecture (300) and the second signal is received as input into a second one (304) of the two neural networks (302, 304) of the twin network architecture (300).

14. The system (100, 200) of claim 11, wherein the trained neural network is an autoencoder (400, 402).

## Patentansprüche

1. Verfahren, umfassend:
Empfangen (600), als eine erste Eingabe in ein trainiertes neuronales Netzwerk, mindestens eines ersten Signals, das akustische Messungen mindestens einer Referenzbatteriezelle repräsentiert;
Empfangen (602), als eine zweite Eingabe in das trainierte neuronale Netzwerk, eines zweiten Signals, das akustische Messungen einer zu prüfenden Batteriezelle repräsentiert;
Durchführen (604), unter Verwendung des trainierten neuronalen Netzwerks, einer Analyse des mindestens einen ersten Signals und des zweiten Signals, um zu bestimmen, ob das zweite Signal eine Schwellenwertähnlichkeit mit dem mindestens einen ersten Signal aufweist; und
Erzeugen (606), als eine Ausgabe des trainierten neuronalen Netzwerks, einer Fehleridentifizierung für die zu prüfende Batteriezelle basierend darauf, ob das zweite Signal die Schwellenwertähnlichkeit mit dem mindestens einen ersten Signal aufweist oder nicht.

2. Verfahren gemäß Anspruch 1,
wobei die Fehleridentifizierung die zu prüfende Batteriezelle als fehlerfrei identifiziert, wenn das zweite Signal die Schwellenwertähnlichkeit mit dem mindestens einen ersten Signal aufweist und das mindestens eine erste Signal ein Signal ist, das eine fehlerfreie Batteriezelle repräsentiert; und/oder
wobei die Fehleridentifizierung die zu prüfende Batteriezelle als einen unbekannten Fehler aufweisend identifiziert, wenn das zweite Signal die Schwellenwertähnlichkeit mit dem mindestens einen ersten Signal nicht aufweist und das mindestens eine erste Signal ein eine fehlerfreie Batteriezelle repräsentierendes Signal und ein oder mehrere zusätzliche Signale umfasst, die einen oder mehrere bekannte Fehler repräsentieren, wobei insbesondere das trainierte neuronale Netzwerk nicht dazu trainiert ist, eine Art des unbekannten Fehlers zu identifizieren.

3. Verfahren gemäß Anspruch 1,
wobei das trainierte neuronale Netzwerk eine Zwillingsnetzwerkarchitektur (300) aufweist und das mindestens eine erste Signal als Eingabe in ein erstes (302) von zwei neuronalen Netzwerken (302, 304) der Zwillingsnetzwerkarchitektur (300) empfangen wird und das zweite Signal als Eingabe in ein zweites (304) der zwei neuronalen Netzwerke (302, 304) der Zwillingsnetzwerkarchitektur (300) empfangen wird.

4. Verfahren gemäß Anspruch 1,
wobei das trainierte neuronale Netzwerk ein Autoencoder (400, 402) ist.

5. Verfahren gemäß Anspruch 1, ferner umfassend:
Reduzieren einer Dimensionalität des mindestens einen ersten Signals und des zweiten Signals unter Verwendung eines rekurrenten neuronalen Netzwerks.

6. Vorrichtung (700), umfassend:
einen oder mehrere Speicher (715, 720, 725, 730), in denen computerlesbare Anweisungen gespeichert sind, die einem trainierten neuronalen Netzwerk entsprechen; und
einen oder mehrere Prozessoren (710), die dazu konfiguriert sind, die computerlesbaren Anweisungen auszuführen zum:
Empfangen (600), als eine erste Eingabe in das trainierte neuronale Netzwerk, mindestens eines ersten Signals, das akustische Messungen mindestens einer Referenzbatteriezelle repräsentiert;
Empfangen (602), als eine zweite Eingabe in das trainierte neuronale Netzwerk, eines zweiten Signals, das akustische Messungen einer zu prüfenden Batteriezelle repräsentiert;
Durchführen (604), unter Verwendung des trainierten neuronalen Netzwerks, einer Analyse des mindestens einen ersten Signals und des zweiten Signals, um zu bestimmen, ob das zweite Signal eine Schwellenwertähnlichkeit mit dem mindestens einen ersten Signal aufweist; und
Erzeugen (606), als eine Ausgabe des trainierten neuronalen Netzwerks, einer Fehleridentifizierung für die zu prüfende Batteriezelle basierend darauf, ob das zweite Signal die Schwellenwertähnlichkeit mit dem mindestens einen ersten Signal aufweist oder nicht.

7. Vorrichtung (700) gemäß Anspruch 6,
wobei die Fehleridentifizierung die zu prüfende Batteriezelle als fehlerfrei identifiziert, wenn das zweite Signal die Schwellenwertähnlichkeit mit dem mindestens einen ersten Signal aufweist und das mindestens eine erste Signal ein Signal ist, das eine fehlerfreie Batteriezelle repräsentiert; und/oder
wobei die Fehleridentifizierung die zu prüfende Batteriezelle als einen unbekannten Fehler aufweisend identifiziert, wenn das zweite Signal die Schwellenwertähnlichkeit mit dem mindestens einen ersten Signal nicht aufweist und das mindestens eine erste Signal ein eine fehlerfreie Batteriezelle repräsentierendes Signal und ein oder mehrere zusätzliche Signale umfasst, die einen oder mehrere bekannte Fehler repräsentieren, wobei insbesondere das trainierte neuronale Netzwerk nicht dazu trainiert ist, eine Art des unbekannten Fehlers zu identifizieren.

8. Vorrichtung (700) gemäß Anspruch 6,
wobei das trainierte neuronale Netzwerk eine Zwillingsnetzwerkarchitektur (300) aufweist und das mindestens eine erste Signal als Eingabe in ein erstes (302) von zwei neuronalen Netzwerken (302, 304) der Zwillingsnetzwerkarchitektur (300) empfangen wird und das zweite Signal als Eingabe in ein zweites (304) der zwei neuronalen Netzwerke (302, 304) der Zwillingsnetzwerkarchitektur (300) empfangen wird.

9. Vorrichtung (700) gemäß Anspruch 6,
wobei das trainierte neuronale Netzwerk ein Autoencoder (400, 402) ist.

10. Vorrichtung (700) gemäß Anspruch 6,
wobei die computerlesbaren Anweisungen ferner Anweisungen umfassen, die einem rekurrenten neuronalen Netzwerk entsprechen und bei deren Ausführung durch den einen oder die mehreren Prozessoren der eine oder die mehreren Prozessoren dazu veranlasst werden, eine Dimensionalität des mindestens einen ersten Signals und des zweiten Signals unter Verwendung des rekurrenten neuronalen Netzwerks zu reduzieren.

11. System (100, 200), umfassend:
eine akustische Anordnung, die dazu konfiguriert ist, eine zu prüfende Batteriezelle akustisch abzutasten; und
ein trainiertes neuronales Netzwerk, das konfiguriert ist zum:
Empfangen (600), als eine erste Eingabe in das trainierte neuronale Netzwerk, mindestens eines ersten Signals, das akustische Messungen mindestens einer Referenzbatteriezelle repräsentiert;
Empfangen (602), als eine zweite Eingabe in das trainierte neuronale Netzwerk, eines zweiten Signals, das akustische Messungen der zu prüfenden Batteriezelle repräsentiert;
Durchführen (604), unter Verwendung des trainierten neuronalen Netzwerks, einer Analyse des mindestens einen ersten Signals und des zweiten Signals, um zu bestimmen, ob das zweite Signal eine Schwellenwertähnlichkeit mit dem mindestens einen ersten Signal aufweist; und
Erzeugen (606), als eine Ausgabe des trainierten neuronalen Netzwerks, einer Fehleridentifizierung für die zu prüfende Batteriezelle basierend darauf, ob das zweite Signal die Schwellenwertähnlichkeit mit dem mindestens einen ersten Signal aufweist oder nicht.

12. System (100, 200) gemäß Anspruch 11,
wobei die Fehleridentifizierung die zu prüfende Batteriezelle als fehlerfrei identifiziert, wenn das zweite Signal die Schwellenwertähnlichkeit mit dem mindestens einen ersten Signal aufweist und das mindestens eine erste Signal ein Signal ist, das eine fehlerfreie Batteriezelle repräsentiert; und/oder
wobei die Fehleridentifizierung die zu prüfende Batteriezelle als einen unbekannten Fehler aufweisend identifiziert, wenn das zweite Signal die Schwellenwertähnlichkeit mit dem mindestens einen ersten Signal nicht aufweist und das mindestens eine erste Signal ein eine fehlerfreie Batteriezelle repräsentierendes Signal und ein oder mehrere zusätzliche Signale umfasst, die einen oder mehrere bekannte Fehler repräsentieren, wobei insbesondere das trainierte neuronale Netzwerk nicht dazu trainiert ist, eine Art des unbekannten Fehlers zu identifizieren.

13. System (100, 200) gemäß Anspruch 11,
wobei das trainierte neuronale Netzwerk eine Zwillingsnetzwerkarchitektur (300) aufweist und das mindestens eine erste Signal als Eingabe in ein erstes (302) von zwei neuronalen Netzwerken (302, 304) der Zwillingsnetzwerkarchitektur (300) empfangen wird und das zweite Signal als Eingabe in ein zweites (304) der zwei neuronalen Netzwerke (302, 304) der Zwillingsnetzwerkarchitektur (300) empfangen wird.

14. System (100, 200) gemäß Anspruch 11,
wobei das trainierte neuronale Netzwerk ein Autoencoder (400, 402) ist.

## Revendications

1. Procédé comprenant :
la réception (600), en tant que première entrée dans un réseau neuronal entraîné, d'au moins un premier signal représentatif de mesures acoustiques d'au moins une cellule de batterie de référence ;
la réception (602), en tant que seconde entrée dans le réseau neuronal entraîné, d'un second signal représentatif de mesures acoustiques d'une cellule de batterie sous test ;
la réalisation (604), à l'aide du réseau neuronal entraîné, d'une analyse dudit au moins un premier signal et du second signal afin de déterminer si le second signal présente une similarité seuil avec ledit au moins un premier signal ; et
la génération (606), en tant que sortie du réseau neuronal entraîné, d'une identification de défaut pour la cellule de batterie sous test, sur la base du fait que le second signal présente ou non la similarité seuil avec ledit au moins un premier signal.

2. Procédé selon la revendication 1,
dans lequel l'identification de défaut identifie la cellule de batterie sous test comme étant sans défaut si le second signal présente la similarité seuil avec ledit au moins un premier signal et ledit au moins un premier signal est un signal représentant une cellule de batterie sans défaut ; et/ou
dans lequel l'identification de défaut identifie la cellule de batterie sous test comme présentant un défaut inconnu si le second signal ne présente pas la similarité seuil avec ledit au moins un premier signal et ledit au moins un premier signal comporte un signal représentant une cellule de batterie sans défaut et un ou plusieurs signaux supplémentaires représentant un ou plusieurs défauts connus, dans lequel, en particulier, le réseau neuronal entraîné n'est pas entraîné pour identifier un type du défaut inconnu.

3. Procédé selon la revendication 1, dans lequel le réseau neuronal entraîné présente une architecture de réseau double (300) et ledit au moins un premier signal est reçu en tant qu'entrée dans un premier réseau neuronal (302) parmi deux réseaux neuronaux (302, 304) de l'architecture double (300) et le second signal est reçu en tant qu'entrée dans un second réseau neuronal (304) parmi les deux réseaux neuronaux (302, 304) de l'architecture de réseau double (300).

4. Procédé selon la revendication 1, dans lequel le réseau neuronal entraîné est un autoencodeur (400, 402).

5. Procédé selon la revendication 1, comprenant en outre :
la réduction d'une dimensionnalité dudit au moins un premier signal et du second signal à l'aide d'un réseau neuronal récurrent.

6. Dispositif (700) comprenant :
une ou plusieurs mémoires (715, 720, 725, 730) présentant des instructions lisibles par ordinateur correspondant à un réseau neuronal entraîné stocké sur celle(s)-ci ; et
un ou plusieurs processeurs (710) configuré(s) pour exécuter les instructions lisibles par ordinateur pour :
la réception (600), en tant que première entrée dans le réseau neuronal entraîné, d'au moins un premier signal représentatif de mesures acoustiques d'au moins une cellule de batterie de référence ;
la réception (602), en tant que seconde entrée dans le réseau neuronal entraîné, d'un second signal représentatif de mesures acoustiques d'une cellule de batterie sous test ;
la réalisation (604), à l'aide du réseau neuronal entraîné, d'une analyse dudit au moins un premier signal et du second signal afin de déterminer si le second signal présente une similarité seuil avec ledit au moins un premier signal ; et
la génération (606), en tant que sortie du réseau neuronal entraîné, d'une identification de défaut pour la cellule de batterie sous test, sur la base du fait que le second signal présente ou non la similarité seuil avec ledit au moins un premier signal.

7. Dispositif (700) selon la revendication 6,
dans lequel l'identification de défaut identifie la cellule de batterie sous test comme étant sans défaut si le second signal présente la similarité seuil avec ledit au moins un premier signal et ledit au moins un premier signal est un signal représentant une cellule de batterie sans défaut ; et/ou
dans lequel l'identification de défaut identifie la cellule de batterie sous test comme présentant un défaut inconnu si le second signal ne présente pas la similarité seuil avec ledit au moins un premier signal et ledit au moins un premier signal comporte un signal représentant une cellule de batterie sans défaut et un ou plusieurs signaux supplémentaires représentant un ou plusieurs défauts connus, dans lequel, en particulier, le réseau neuronal entraîné n'est pas entraîné pour identifier un type du défaut inconnu.

8. Dispositif (700) selon la revendication 6, dans lequel le réseau neuronal entraîné présente une architecture de réseau double (300) et ledit au moins un premier signal est reçu en tant qu'entrée dans un premier réseau neuronal (302) parmi deux réseaux neuronaux (302, 304) de l'architecture double (300) et le second signal est reçu en tant qu'entrée dans un second réseau neuronal (304) parmi les deux réseaux neuronaux (302, 304) de l'architecture de réseau double (300).

9. Dispositif (700) selon la revendication 6, dans lequel le réseau neuronal entraîné est un autoencodeur (400, 402).

10. Dispositif (700) selon la revendication 6, dans lequel les instructions lisibles par ordinateur comportent en outre des instructions correspondant à un réseau neuronal récurrent, qui, lorsqu'elles sont exécutées par ledit un ou lesdits plusieurs processeurs, amène ledit un ou lesdits plusieurs processeurs à réduire une dimensionnalité dudit au moins un premier signal et du second signal à l'aide du réseau neuronal récurrent.

11. Système (100, 200) comprenant :
un réseau acoustique configuré pour balayer acoustiquement une cellule de batterie sous test ; et un réseau neuronal entraîné configuré pour :
recevoir (600), en tant que première entrée dans le réseau neuronal entraîné, au moins un premier signal représentatif de mesures acoustiques d'au moins une cellule de batterie de référence ;
recevoir (602), en tant que seconde entrée dans le réseau neuronal entraîné, un second signal représentatif de mesures acoustiques de la cellule de batterie sous test ;
réaliser (604), à l'aide du réseau neuronal entraîné, une analyse dudit au moins un premier signal et du second signal afin de déterminer si le second signal présente une similarité seuil avec ledit au moins un premier signal ; et
générer (606), en tant que sortie du réseau neuronal entraîné, une identification de défaut pour la cellule de batterie sous test, sur la base du fait que le second signal présente ou non la similarité seuil avec ledit au moins un premier signal.

12. Système (100, 200) selon la revendication 11,
dans lequel l'identification de défaut identifie la cellule de batterie sous test comme étant sans défaut si le second signal présente la similarité seuil avec ledit au moins un premier signal et ledit au moins un premier signal est un signal représentant une cellule de batterie sans défaut ; et/ou
dans lequel l'identification de défaut identifie la cellule de batterie sous test comme présentant un défaut inconnu si le second signal ne présente pas la similarité seuil avec ledit au moins un premier signal et ledit au moins un premier signal comporte un signal représentant une cellule de batterie sans défaut et un ou plusieurs signaux supplémentaires représentant un ou plusieurs défauts connus, dans lequel, en particulier, le réseau neuronal entraîné n'est pas entraîné pour identifier un type du défaut inconnu.

13. Système (100, 200) selon la revendication 11, dans lequel le réseau neuronal entraîné présente une architecture de réseau double (300) et ledit au moins un premier signal est reçu en tant qu'entrée dans un premier réseau neuronal (302) parmi deux réseaux neuronaux (302, 304) de l'architecture double (300) et le second signal est reçu en tant qu'entrée dans un second réseau neuronal (304) parmi les deux réseaux neuronaux (302, 304) de l'architecture de réseau double (300).

14. Système (100, 200) selon la revendication 11, dans lequel le réseau neuronal entraîné est un autoencodeur (400, 402).
